# EUROPÄISCHE PATENTSCHRIFT

(11) **EP 0 560 086 B1**
(45) Veröffentlichungstag und Bekanntmachung des Hinweises auf die Patenterteilung: **23.04.1997**
(21) Anmeldenummer: 93102397.2
(22) Anmeldetag: 16.02.1993
(51) Int. Cl.: H03K 17/08

(54) **Schutzschaltung für einen Leistungs-MOSFET, der eine induktive Last treibt**
Protection circuit for a power-MOSFET driving an inductive load
Circuit de protection pour un transistor à effet de champ MOS de puissance attaquant une charge inductive

(30) Priorität: 10.03.1992 DE 4207590
(43) Veröffentlichungstag der Anmeldung: 15.09.1993
(73) Patentinhaber: SIEMENS AKTIENGESELLSCHAFT, 80333 München (DE)
(72) Erfinder: Feldtkeller, Martin, Dipl.-Ing., W-8000 München 80 (DE)

(56) Entgegenhaltungen:
- EP-A- 0 236 158
- EP-A- 0 382 906
- US-A- 3 936 725
- PATENT ABSTRACTS OF JAPAN, Bd. 15, Nr. 323 (E-1101)16. August 1991 & JP-A-03 119 812
- RADIO FERNSEHEN ELEKTRONIK Bd. 27, Nr. 10 , Oktober 1978 , BERLIN DD Seiten 621 - 625 KRÖBEL 'Grundschaltungen der ananlogen integrierten Technik'

## Beschreibung

Die Erfindung betrifft eine Schutzschaltung gemäß dem Oberbegriff des Anspruchs 1.

Werden elektronische Leistungsschalter zum Schalten induktiver Lasten verwendet, so muß die beim Abschalten freiwerdende induktive Energie vom Leistungsschalter gelöscht werden. Der Laststrom muß dazu weiter über den Leistungsschalter fließen können, der Spannungsabfall am Leistungsschalter muß jedoch wesentlich größer als die Versorgungsspannung des Lastkreises sein, damit sich die Spannung an der Last umkehren kann. Aus der EP-0 380 881 A2 ist bekannt, daß der Gate- und Drainanschluß eines Leistungstransistors, bzw. der Kollektor- und Basisanschluß bei Bipolartransistoren, mit einer Serienschaltung aus einer entsprechenden Anzahl Zenerdioden und in Flußrichtung gepolten Dioden zu verbinden ist. Eine derartige Anordnung ist z. B. in Figur 1 der EP-0 380 881 A2 dargestellt. Schaltet die Steuerspannung den Leistungstransistor ab, so steigt die Drainspannung an, bis über die Zenerdiodenkette Strom zu fließen beginnt und der Transistor damit wieder aufgesteuert wird.

Nachteilig ist, daß diese sogenannte Abkommutierspannung und deren Temperaturkoeffizient sich nur in relativ groben technologiebedingten Schritten einstellen läßt. Ein weiterer Nachteil ist, daß die Abkommutierspannung und deren Temperaturkoeffizient mit den Technologieparametern stark streuen und weiterhin daß das Prasseln der Zenerdioden EMV-Probleme verursacht.

In Figur 2 der EP-0 380 881 A2 ist eine Anordnung angegeben, die obengenannte Nachteile behebt, indem sie die über einen Widerstandsteiler heruntergeteilte Ausgangsspannung mit einer intern erzeugten Referenz vergleicht. Mit dem daraus resultierenden Signal wird dann der Leistungstransistor entsprechend aufgesteuert. Diese Schaltungsanordnung hat aber den Nachteil, daß sie bei Ausfall der Versorgungsspannung noch eventuell vorhandene Energie nicht ableitet und dadurch der Leistungstransistor möglicherweise zerstört werden kann.

Aus der EP-0 382 906 ist eine Schaltungsanordnung, insbesondere aus Figur 3, bekannt, die eine Steuereinrichtung 8, 14, 15 aufweist, die aus der an den Laststreckenanschlüssen des Transistors 4 anliegenden Spannung gespeist wird. Nachteilig ist, daß der Ansteuerstrom von der Versorgungsspannung abhängig ist.

Aufgabe der Erfindung ist es daher, eine Schutzschaltung anzugeben, die die zuvor genannten Nachteile behebt.

Diese Aufgabe wird durch den kennzeichnenden Teil des Anspruchs 1 gelöst. Weiterbildungen sind Kennzeichen der abhängigen Ansprüche.

Die erfindungsgemäße Lösung stellt im wesentlichen einen Parallelregler dar, bei dem der Leistungstransistor in den Regelkreis miteinbezogen ist. Dieser Parallelregler ist vorteilhafterweise unabhängig von der Versorgungsspannung der Ansteuerschaltung und deshalb ist seine Aktivierung nur von der an der Laststrecke des Leistungstransistors anliegenden Spannung abhängig.

Die Erfindung wird nachfolgend anhand von zwei Figuren näher erläutert:
- Figur 1: zeigt eine prinzipielle Schutzschaltungsanordnung,
- Figur 2: zeigt das erfindungsgemäße Ausführungsbeispiel der Schutzschaltungsanordnung.

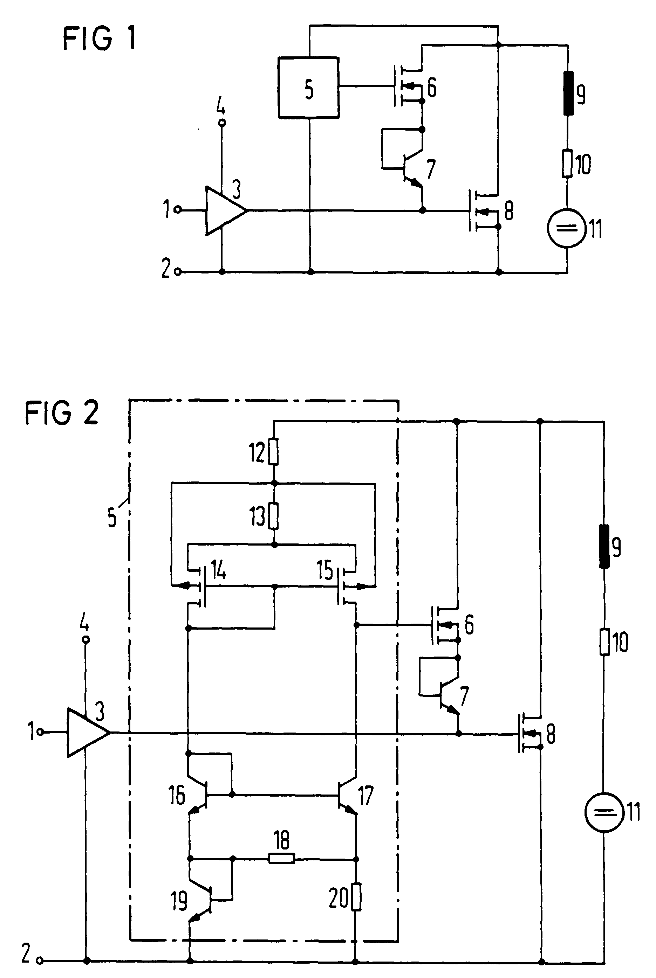

Die in Figur 1 dargestellte Schaltungsanordnung weist zwei Eingangsklemmen 1, 2 auf. Der Eingangsklemme 1 wird ein Steuersignal zugeführt und an der Eingangsklemme 2 liegt ein Bezugspotential an. Die Eingangsklemme 1 ist mit einem Eingang einer Ansteuerschaltung 3 verbunden. Diese Ansteuerschaltung 3 ist weiterhin mit dem an der Eingangsklemme 2 anliegenden Bezugspotential sowie einer an einer weiteren Eingangsklemme 4 anliegenden Versorgungsspannung verbunden. Die Ansteuerschaltung 3 erzeugt ein Ausgangssignal das dem Gateanschluß eines Leistungs-MOSFET 8 zugeführt wird. Die Laststrecke des Leistungs-MOSFET 8 ist einerseits mit dem Bezugspotential und andererseits mit dem ersten Anschluß einer Induktivität 9 verbunden. Der zweite Anschluß der Induktivität 9 ist über einen ohmschen Widerstand 10 mit dem ersten Anschluß einer Versorgungsspannungsquelle 11 verbunden. Die induktive Last setzt sich aus der Induktivität 9 und dem ohmschen Widerstand 10 zusammen. Der zweite Anschluß der Versorgungsspannungsquelle 11 ist mit dem Bezugspotential verschaltet. Zwischen dem Drainanschluß und dem Gateanschluß des Leistungs-MOSFET 8 ist eine Reihenschaltung, bestehend aus der Laststrecke eines weiteren MOSFET 6 und einem als Diode geschalteten bipolaren Transistors 7 geschaltet. Eine Steuereinrichtung 5 mit zwei Eingängen und einem Ausgang ist vorgesehen, deren erster Eingang mit dem Bezugspotential und deren zweiter Eingang mit dem Drainanschluß des Leistungs-MOSFET 8 verschaltet ist. Der Ausgang der Steuereinrichtung 5 ist mit dem Gateanschluß des MOSFET 6 verschaltet.

Figur 2 stimmt im wesentlichen mit Figur 1 überein, so daß gleiche Bauelemente gleiche Bezeichnung haben. Die Steuerschaltung 5 ist hier in der konkreten erfindungsgemäßen Ausführungsform dargestellt. Die Steuerschaltung 5 enthält zwei in Reihe geschaltete Widerstände 12, 13, wobei die Reihenschaltung einerseits mit dem Drainanschluß des Leistungs-MOSFET 8 verbunden ist und andererseits mit den Sourceanschlüssen von zwei weiteren MOSFET 14, 15. Die Gateanschlüsse der MOSFETS 14 und 15 sind miteinander verbunden. Weiterhin ist der Gateanschluß des MOSFET 14 mit seinem Drainanschluß verschaltet. Die Substratanschlüsse der beiden MOSFET 14 und 15 sind mit dem Knotenpunkt der Reihenschaltung der beiden Widerstände 12 und 13 verschaltet. Der Drainanschluß des MOSFET 14 ist mit dem Eingangskreis einer Stromspiegelanordnung verbunden und der Drainanschluß des MOSFET 15 mit dem Ausgangskreis dieser Stromspiegelanordnung. Weiterhin ist der Drainanschluß des MOSFET 15 mit dem Gateanschluß des MOSFET 6 verschaltet.

Die Stromspiegelanordnung besteht aus drei bipolaren Transistoren 16, 17, 19 und zwei Widerständen 18, 20. Der Drainanschluß des MOSFET 14 ist mit dem Kollektor und mit der Basis des Transistors 16 verschaltet. Der Emitter des Transistors 16 ist über die Kollektor-Emitter-Strecke des Transistors 19 mit dem Bezugspotential verbunden. Kollektor und Basis des Transistors-19 sind kurzgeschlossen und weiterhin mit dem ersten Anschluß des Widerstands 18 verbunden. Die Basis des Transistors 16 ist weiterhin mit der Basis des Transistors 17 verbunden. Dessen Emitter ist mit dem zweiten Anschluß des Widerstands 18 und über einen Widerstand 20 mit dem Bezugspotential verschaltet. Schließlich ist der Kollektor mit dem Drainanschluß des MOSFET 15 verbunden.

Als Referenzspannung für die Steuereinrichtung 5 dienen ähnlich wie bei einer Bandgap-Referenz die Emitter-Basis-Spannung des Transistors 19 und die Differenz der beiden Emitter-Basis-Spannungen der Transistoren 16 und 17 bei unterschiedlicher Stromdichte. Der Strom über die Widerstände 12 und 13 ist abzüglich der Schwellspannungen der Transistoren 16 und 19 sowie des MOSFET 14 proportional der Spannung an der Laststrecke des Leistungs-MOSFET 8 und teilt sich entsprechend dem Kanalweitenverhältnis der beiden MOSFET 14 und 15 auf die beiden bipolaren Transistoren 16 und 17 auf.

Der aus den drei Transistoren 16, 17 und 19 sowie den beiden Widerständen 18 und 20 bestehende Stromspiegel hat ein mit zunehmendem Strom abnehmendes Übersetzungsverhältnis, so daß bei einer bestimmten Ausgangsspannung der Drainstrom aus dem MOSFET 15 größer wird als der Kollektorstrom des bipolaren Transistors 17 und die Kollektor-Emitter-Spannung des Transistors 17 ansteigt. Ein Anstieg der Gatespannung des MOSFET 6 bewirkt, daß auch die Gatespannung des Leistungs-MOSFET 8 angehoben wird.

Der als Diode geschaltete Transistor 7 verhindert, daß bei aufgesteuerten Leistungs-MOSFET 8 das Gate über die Laststrecke des MOSFET 6 entladen wird.

Über den Substratsteuereffekt der beiden MOSFET 14 und 15 wird sichergestellt, daß die Gatespannung des MOSFET 6 nur dann über die Schwellspannung des MOSFET 6 und des MOSFET 8 ansteigen kann, wenn der Stromspiegel 16..20 ausreichend mit Strom versorgt wird und in seinem Funktionsbereich arbeitet.

Die angegebene Schutzschaltungsanordnung ist nicht auf Schutzschaltungen für Leistungs-MOSFETS beschränkt sondern ebenso gut bei bipolaren Leistungstransistoren anwendbar.

## Patentansprüche

1. Schutzschaltungsanordnung für einen Leistungstransistor (8) in dessen Laststrecke eine induktive Last (9, 10) geschaltet ist, mit einem Transistor (6) dessen Laststrecke zwischen einem ersten Laststreckenanschluß und dem Steueranschluß des Leistungstransistors (8) geschaltet ist, sowie einer Steuereinrichtung (5) die ein Steuersignal erzeugt, welches dem Steueranschluß des Transistors (6) zugeführt wird, wobei die Steuereinrichtung (5) von der an den Laststreckenanschlüssen des Leistungstransistors (8) anliegenden Spannung versorgt wird, **dadurch gekennzeichnet,** daß die Steuereinrichtung (5) zwei MOSFET (14, 15) aufweist, deren Gateanschlüsse miteinander und deren Sourceanschlüsse miteinander verbunden sind, wobei der Gateanschluß des ersten MOSFET (14) mit seinem Drainanschluß verschaltet ist, und wobei die miteinander verbundenen Sourceanschlüsse mit dem ersten Laststreckenanschluß des Leistungstransistors (8) gekoppelt sind, und daß die Steuereinrichtung (5) eine Stromspiegelschaltung (16, 17, 18, 19, 20) aufweist, deren Eingangskreis mit dem Drainanschluß des ersten MOSFET (14) und deren Ausgangskreis mit dem Drainanschluß des zweiten MOSFET (15) verbunden ist, wobei das Steuersignal am Drainanschluß des zweiten MOSFET (15) abgreifbar ist und das Übersetzungsverhältnis der Stromspiegelschaltung (16...20) mit zunehmendem Strom abnimmt.

2. Schutzschaltungsanordnung nach Anspruch 1,
**dadurch gekennzeichnet,** daß zwischen dem Steueranschluß des Leistungstransistors (8) und der Laststrecke des Transistors (6) eine Diode (7) geschaltet ist.

3. Schaltungsanordnung nach Anspruch 1 oder 2,
**dadurch gekennzeichnet,** daß die Steuereinrichtung (5) einen ersten und zweiten Widerstand (12, 13) aufweist, die zwischen dem ersten Laststreckenanschluß des Leistungstransistors (8) und den Sourceanschlüssen der beiden MOSFETS (14, 15) in Reihe geschaltet sind und der Knotenpunkt der Reihenschaltung mit jeweils dem Substratanschluß der MOSFETs (14, 15) verbunden ist.

4. Schaltungsanordnung nach einem der Ansprüche 1 bis 3,
**dadurch gekennzeichnet,** daß die Stromspiegelschaltung (16...20) einen ersten Transistor (16) aufweist, dessen Kollektor mit seiner Basis verbunden ist und den Eingangskreis bildet, dessen Emitter mit dem Kollektor und der Basis eines zweiten Transistors (19) verbunden ist, dessen Emitter mit einem Bezugspotential verschaltet ist, einen dritten Transistor (17) aufweist, dessen Kollektor mit dem Ausgangskreis verbunden ist, dessen Basis mit der Basis des ersten Transistors (16) verschaltet ist, dessen Emitter einerseits über einen Widerstand (18) mit dem Kollektor des zweiten Transistors (19) und andererseits über einer weiteren Widerstand (20) mit dem Bezugspotential verbunden ist.

## Claims

1. Protective circuit arrangement for a power transistor (8), into the load path of which an inductive load (9, 10) is connected, having a transistor (6), the load path of which is connected between a first load path connection and the control connection of the power transistor (8), as well as a control device (5), which generates a control signal which is fed to the control connection of the transistor (6), the control device (5) being supplied by the voltage applied to the load path connections of the power transistor (8), characterized in that the control device (5) has two MOSFETs (14, 15), the gate connections of which are connected to one another and the source connections of which are connected to one another, the gate connection of the first MOSFET (14) being connected up to its drain connection, and the interconnected source connections being coupled to the first load path connection of the power transistor (8), and in that the control device (5) has a current mirror circuit (16, 17, 18, 19, 20), the input circuit of which current mirror circuit is connected to the drain connection of the first MOSFET (14) and the output circuit of which current mirror circuit is connected to the drain connection of the second MOSFET (15), it being possible to pick off the control signal at the drain connection of the second MOSFET (15), and the translation ratio of the current mirror circuit (16...20) decreasing as the current increases.

2. Protective circuit arrangement according to Claim 1, characterized in that a diode (7) is connected between the control connection of the power transistor (8) and the load path of the transistor (6).

3. Circuit arrangement according to Claim 1 or 2, characterized in that the control device (5) has a first and a second resistor (12, 13) which are connected in series between the first load path connection of the power transistor (8) and the source connections of the two MOSFETs (14, 15), and the junction point of the series circuit is connected in each case to the substrate connection of the MOSFETs (14, 15).

4. Circuit arrangement according to one of Claims 1 to 3, characterized in that the current mirror circuit (16...20) has a first transistor (16), the collector of which transistor (16) is connected to its base and forms the input circuit, and the emitter of which transistor (16) is connected to the collector and to the base of a second transistor (19), the emitter of which transistor (19) is connected up to a reference-earth potential, and the said current mirror circuit has a third transistor (17), the collector of which transistor (17) is connected to the output circuit, the base of which transistor (17) is connected up to the base of the first transistor (16), and the emitter of which transistor (17) is connected, on the one hand, via a resistor (18) to the collector of the second transistor (19) and, on the other hand, via a further resistor (20) to the reference-earth potential.

## Revendications

1. Montage de protection d'un transistor (8) de puissance, dans la voie de charge duquel est branchée une charge inductive (9, 10), comportant un transistor (6), dont la voie de charge est branchée entre une première borne de voie de charge et la borne de commande du transistor (8) de puissance, ainsi qu'un dispositif (5) de commande produisant un signal de commande, qui est envoyé à la borne de commande du transistor (6), le dispositif (5) de commande étant alimenté par la tension s'appliquant aux bornes de la voie de charge du transistor (8) de puissance,
caractérisé en ce que le dispositif (5) de commande comporte deux MOSFETS (14, 15), dont les bornes de grille sont reliées entre elles et dont les bornes de source sont reliées entre elles, la borne de grille du premier MOSFET (14) étant branchée à sa borne de drain et les bornes de source reliées entre elles sont couplées à la première borne de voie de charge du transistor (8) de puissance et le dispositif (5) de commande comporte un circuit (16, 17, 18, 19, 20) de miroir de courant dont le circuit d'entrée est relié à la borne de drain du premier MOSFET (14) et dont le circuit de sortie est relié à la borne de drain du second MOSFET (15), le signal de commande pouvant être prélevé de la borne de drain du second MOSFET (15) et le rapport de conversion du circuit (16 à 20) de miroir de courant diminuant lorsque le courant augmente.

2. Montage de protection suivant la revendication 1,
caractérisé en ce qu'une diode (7) est branchée entre la borne de commande du transistor (8) de puissance et la voie de charge du transistor (6).

3. Montage suivant la revendication 1 ou 2,
caractérisé en ce que le dispositif (5) de commande comporte une première et une seconde résistance (12, 13), qui sont branchées en série entre la première borne de la voie de charge du transistor (8) de puissance et les bornes de source des deux MOSFETS (14, 15) et le noeud du circuit série est relié à la borne de substrat de chaque MOSFET (14, 15)

4. Montage suivant l'une des revendications 1 à 3,
caractérisé en ce que le circuit (16 à 20) de miroir de courant comporte un premier transistor (16), dont le collecteur est relié à la base et forme le circuit d'entrée, dont l'émetteur est relié au collecteur et à la base d'un second transistor (19), dont l'émetteur est branché à un potentiel de référence, un troisième transistor (17), dont le collecteur est relié au circuit de sortie, dont la base est branchée à la base du premier transistor (16) et dont l'émetteur est relié d'une part par l'intermédiaire d'une résistance (18) au collecteur du second transistor (19) et d'autre part par l'intermédiaire d'une autre résistance (20) au potentiel de référence.
